# EUROPEAN PATENT APPLICATION

(11) **EP 4 468 605 A1**
(43) Date of publication of application: **27.11.2024**
(21) Application number: 23214892.4
(22) Date of filing: 07.12.2023
(51) Int. Cl.: H03K 17/06, H03K 17/0812, H03K 17/082, H03K 17/567

(54) **FLOATING LEVEL SHIFTER FOR DC-DC CONVERTER**

(30) Priority: 26.05.2023 US 202318324865
(71) Applicant: INTEL Corporation, Santa Clara, CA 95054 (US)
(72) Inventor: AMIN, Sally Safwat, Hillsboro, OR 97124 (US)
(74) Representative: HGF

(57) **Abstract**

Embodiments herein relate to a voltage converter with a floating level shifter. The floating level shifter is implemented on a silicon substrate using complementary metal-oxide semiconductor (CMOS) technology while the power train is implemented on a Gallium Nitride substrate. The floating level shifter may be all-digital and avoid the use of passive devices. The floating level shifter is responsive to a voltage output from a bootstrap circuit, a voltage of a switching node of a power train and a drive voltage of the bootstrap circuit, to shift an input signal to an output signal in a charge phase of a switching cycle. The output signal drives a high-side driver for a high-side transistor of the power train, where the voltage output from the bootstrap circuit and the voltage of the switching node alternate in charge and discharge phases of the switching cycle.

## Description

### FIELD

The present application generally relates to the field of direct current-to-direct current (DC-DC) voltage converters and, more particularly, to a floating level shifter for such a voltage converter.

### BACKGROUND

DC-to-DC voltage converters, also referred to as power converters, are useful for converting a power supply at one voltage to another voltage. For example, a voltage converter can convert the main supply voltage of a computing device, such as 12 V, down to lower voltages, such as 5 V, 3.3 V or 1.8 V. The lower voltages can be used by various components in the computing device. These components can include a Universal Serial Bus (USB) interface, memory such as dynamic random access memory (DRAM) and processing resources such as a central processing unit (CPU). However, various challenges are presented in operating a voltage converter.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts an example GaN-based DC-to-DC voltage converter 100, in accordance with various embodiments.
FIG. 2 depicts example waveforms in a switching cycle of the converter of FIG. 1, including an ideal case and a false trigger case, in accordance with various embodiments.
FIG. 3 depicts an example implementation of the floating level shifter 115 of FIG. 1 as a floating level shifter 315 which uses passive devices and special high-voltage devices.
FIG. 4 depicts an example implementation of the floating level shifter 115 of FIG. 1 as a floating level shifter 415 which avoids using passive devices and special high-voltage devices, in accordance with various embodiments.
FIG. 5A depicts an example implementation of the stacked level shifter 410 of FIG. 4, in accordance with various embodiments.
FIG. 5B depicts example waveforms representing the input signals to the logic circuit 550 of FIG. 5A, in accordance with various embodiments.
FIG. 5C depicts a truth table consistent with the NOR gate 555 of the logic circuit of FIG. 5A, in accordance with various embodiments.
FIG. 5D depicts a truth table consistent with the NOR gate 560 of the logic circuit of FIG. 5A, in accordance with various embodiments.
FIG. 6A depicts an example implementation of a circuit 600 which includes the stacked top floating level shifter 420, stacked bottom floating level shifter 430 and the Vsw sensing and clipping circuit 440 of FIG. 4, in accordance with various embodiments.
FIG. 6B depicts an example configuration of the circuit of FIG. 6A during an inductor discharge phase, in accordance with various embodiments.
FIG. 6C depicts an example configuration of the circuit of FIG. 6A during an inductor charge phase, in accordance with various embodiments.
FIG. 6D depicts an example configuration of the circuit of FIG. 6A during an off state, in accordance with various embodiments.
FIG. 7 depicts example waveforms representing the operation of the circuit of FIG. 6A, in accordance with various embodiments.
FIG. 8 illustrates an example of components that may be present in a computing system 850 for implementing the techniques (e.g., operations, processes, methods, and methodologies) described herein.

### DETAILED DESCRIPTION

As mentioned at the outset, various challenges are presented in operating a voltage converter.

High-frequency, high-voltage GaN-based DC-DC voltage converters are expected to replace conventional complementary metal-oxide semiconductor (CMOS) technology due to their superior figures of merit and high-voltage capability. CMOS is a type of metal-oxide-semiconductor field-effect transistor fabrication process that uses complementary and symmetrical pairs of p-type and n-type MOSFETs in silicon for logic functions. Gallium Nitride (GaN) is a stable, wide bandgap semiconductor which has a higher breakdown strength, faster switching speed, higher thermal conductivity and lower on-resistance than silicon-based devices. To fabricate the transistors, Gallium Nitride crystals can be grown as an epitaxial layer on substrates such as sapphire, silicon carbide (SiC) and silicon (Si).

In a high-voltage buck converter implemented using special devices like GaN, n-type devices (transistors) are used in both the low side (LS) and high side (HS) because of their excellent figures of merit compared to p-type devices. To turn ON and OFF the HS n-type device, the HS gate voltage level, VgHS, should be set in reference to its source voltage level, Vsw, which is connected to the inductor switching node.

A floating level shifter can be used to generate an output which is function of the level shifter input, lsh_in, compatible with low-voltage CMOS, switching between 0 and a driver voltage, Vdrv, to turn OFF and ON the HS device, respectively. The output is also a function of the inductor switching node voltage, Vsw, where VgHS =lsh_out=Vsw+ lsh_in. However, the HS and LS devices and the inductor switching node are incompatible with the low-voltage CMOS process when they are implemented on a GaN substrate.

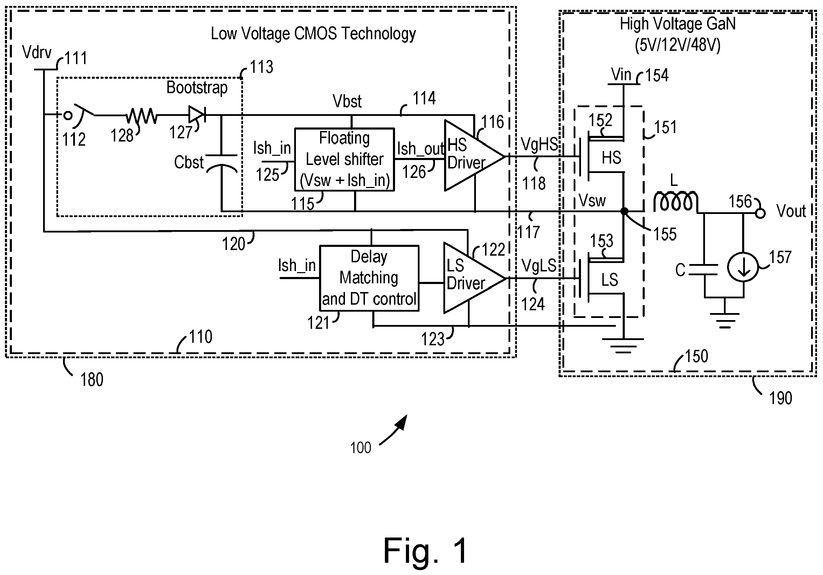

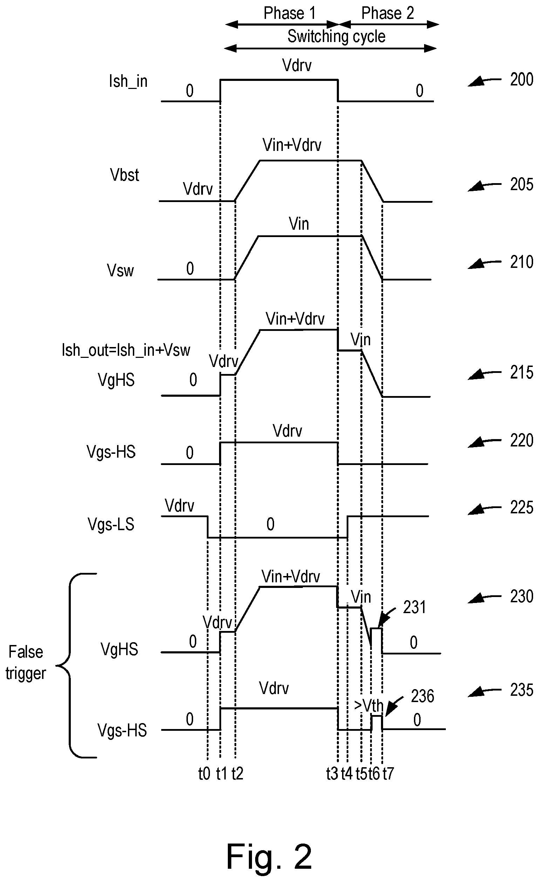

Unlike conventional level shifters used in CMOS fully-integrated voltage regulators, the floating level shifters rails are not at static power and ground. Instead, they are high-voltage switching signals (i.e., at a bootstrap voltage, Vbst, and at Vsw, respectively) as shown in FIG. 1. FIG. 1 shows an example GaN-based DC-DC converter block diagram including power train, drivers, bootstrap circuit and floating level shifter while FIG. 2 shows the waveforms of an ideal floating level shifter and power train gate-to-source voltage. High-speed and small form-factor level shifters that meet low leakage specifications are needed for high switching frequency (Fsw) operation and high-density integrated power management integrated circuits (PMICs), especially for applications with stringent leakage requirements such as client platforms.

However, various challenges are presented in designing a floating level shifter. For example, first, in a GaN-based voltage regulator (VR), the output of the floating level shifter must be function of both Vsw and lsh_in, even during transitions, to ensure proper control of the HS gate-to-source voltage, Vgs-HS, and avoid glitches that can lead to efficiency degradation and reliability concerns. Second, low-voltage devices in CMOS technology, which are the available options to implement the floating level shifter, cannot support the level shifter high-voltage implementation requirement. Third, solutions including using high-voltage laterally-diffused metal-oxide semiconductor (LDMOS) and/or passive devices (e.g., resistors and capacitors) to overcome the low-voltage CMOS challenges result in a large area and high leakage implementation, which is unsuitable for applications with stringent leakage requirements such as client platform. Fourth, the level shifter power and ground (GND) rails are both switching. During a Vbst and Vsw transition, the high dV/dt triggers a high coupling current to charge the parasitic capacitance, potentially creating a false trigger at the level shifter output (see FIG. 2), which results in shoot-through and an efficiency degradation. Moreover, this problem is worse in high-voltage, high-switching frequency and high current converters where dV/dt is higher. dV/dt refers to rapid voltage changes across a transistor which can result in switching losses.

Potential solutions for blocking the high-voltage include an implementation using analog-based circuits and special process devices (e.g., LDMOS) and/or using passive devices. For example, one possible solution for improving the high dV/dt impact is to use large damping resistors in series with the level shifter output devices to dampen the coupling current and improve the dV/dt immunity.

However, these solutions have a number of disadvantages. For example, using special devices like LDMOS to block the high-voltage makes the level shifter design bounded to a specific technology and constrained to having LDMOS high-voltage devices with a voltage rating equal to the maximum input voltage (Vin), which can be as high as 48 V, for example. In addition, integrating these special devices with CMOS in a level shifter design would result in a large area and switching frequency limitation due to the high parasitics resulting from the layout spacing constraints between CMOS and LDMOS.

Using passives such as resistors and capacitors would not require a special process but again would require a process with resistors and capacitors with a voltage rating equal to the maximum Vin rating, resulting in a large area and process variation dependency. In addition, a conventional analog-based implementation (used to reduce high-voltage stress on the low voltage devices) results in high static/leakage current that would make the architecture unsuitable for applications such as client applications that have a stringent leakage specification or are required to support a low load current range. On the other hand, traditional damping resistors added to improve the dV/dt immunity result in a huge area and slow transitions/low speed.

The solutions described herein address the above and other issues. The solution provides an architecture and circuits which result in implementing an all-digital high-voltage dV/dt immune, floating level shifter using only low voltage CMOS devices with no special devices or passives. The solution involves sensing and clipping an inductor switching node voltage, Vsw, converting it into two switching signals with different levels acting as ground rails, namely Vsp and Vsn, for two sublevel shifters, referred to as top and bottom level shifters. A high peak switching new ground rail, Vsp, switches between Vin-Vdrv and Vin and a low peak switching new ground rail, Vsn, switches between 0 and Vdrv.

The solutions can further include multiplexing the output of the two sublevel shifters which are enabled and disabled by controlling their power rails according to the sensed Vsw.

The solutions provide an all-digital implementation to eliminate the impact of high dV/dt switch transients at Vsw by tapping the output from a completely OFF branch (with current 1=0). This approach blocks coupling currents and false trigger results from a high dV/dt, making the floating level shifter immune to any high dV/dt transition and suitable for high-frequency, high-voltage applications with no efficiency penalty.

The solutions can further include stacking low-voltage CMOS devices in addition to the clipped new rails to block the high-voltage that increases up to Vin-Vdrv, allowing the solution to work for any Vin range, including 5V/12V/48V, without exceeding the maximum voltage rating of low voltage CMOS devices used in the level shifter (Vdrv).

The solutions have a number of advantages, including enabling a reliable, high frequency, high-voltage PMIC-based solution with high power density, and eliminating the need for two-stage converters to improve the end-to-end efficiency and reduce the area. Bringing in a higher voltage VR minimizes the input current which greatly reduces the power distribution losses (RLoss) in higher current applications such as servers and graphics processing units (GPUs). Moreover, pushing the switching frequency reduces the die area/cost, decoupling and inductor size and improves load line performance. In addition, the solutions can facilitate enabling magnetic material-based inductors which can eliminate the inductor footprint on the client platforms that is currently the most dominating area cost.

The solutions can be used, for instance, in PMIC chips with discrete inductors or chiplets integrated in a package with package-integrated inductors with high input voltages coming in from the platform. The floating level-shifter circuit can be used in high-voltage PMIC where its power train is based on N-N topology, e.g., the high-side and low-side transistors of the power train are N-devices. The N-N topology is built using special devices such as LDMOS or GaN, which have an asymmetric drain and source.

These and other features will be further apparent in view of the following discussion.

FIG. 1 depicts an example GaN-based DC-to-DC voltage converter 100, in accordance with various embodiments. A first, CMOS portion 110 of the voltage converter can be provided using low-voltage CMOS technology while a second portion 150 is GaN-based, for example. The CMOS portion 110 (a driver or driver portion in the voltage converter 100) is fabricated on a silicon substrate 180 and the portion 150 may be fabricated on a GaN substrate 190. The GaN-based portion 150 (a driven portion of the voltage converter 100) can operate at high-voltages such as Vin=5V/12V/48V. The CMOS portion 110 also refers to a driver of the voltage regulator, while the GaN portion includes a power train 151 which is driven by the driver.

The circuit includes a power train (PTR), drivers, bootstrap circuit and floating level shifter. In particular, the CMOS portion 110 includes an input node 111 which receives a drive voltage, Vdrv. Vdrv may be a fixed voltage. Vdrv is provided to a bootstrap circuit 113 which includes a switch 112, a resistor 128, diode 127 and a bootstrap capacitor Cbst. A bootstrap circuit allows a voltage signal to be increased above its maximum voltage level. The capacitor is charged during one part of a cycle and then used to supply additional voltage during another part of the cycle. When the switch is closed (conductive),

The voltage converter may be a step down converter in which Vout<Vdrv. The converter works by alternately turning the HS and LS transistors on. When the LS transistor is on, a circuit path is completed from the node 111 through the switch, resistor, Cbst and LS transistor to ground. At this time, Cbst is charged up by the node 111 until its voltage is equal to Vdrv. When the LS transistor is turned off and the HS transistor is turned on, a switching voltage Vsw increases to Vin, and the diode is reversed biased since Vin>Vdrv. The voltage across Cbst is maintained so that a bootstrap voltage, Vbst, increases by about Vin, to Vdrv+Vin. As a result, a voltage which is higher than Vin is obtained for use in driving the HS transistor.

Vbst, is provided on a path 114 to a floating level shifter 115 and a high-side (HS) driver 116, Vsw is provided on a path 117 to the floating level shifter 115 and the HS driver 116. The floating level shifter 115 provides an output voltage or output signal, lsh_out (lsh denotes level shifter) which is based on the sum of an input voltage lsh_in and Vsw. lsh_in can alternate between 0 V and Vdrv. The output is thus upshifted relative to the input. The HS driver 116 receives lsh_out=lsh_in+Vsw and provides a corresponding voltage VgHS on a path 118 to a control gate of the HS transistor 152.

lsh_in and Vsw can be provided by respective voltage drivers/sources. lsh_in is received on an input path 125 and lsh_out is provided on an output path 126.

Vdrv is also provided on a path 120 to a delay matching and DT control circuit 121 and a low side (LS) driver 122. These circuits are grounded at one side via a path 123. The delay matching and DT control circuit 121 (a delay circuit) receives lsh_in and provides a corresponding output to the LS driver. DT denotes a dead time which is achieved by controlling the delay between the high side and low side power switch control signals, VgHS and VgLS, respectively, by taking into account the delay of floating level shifter. The LS driver 122 in turn provides a corresponding voltage VgLS on a path 124 to a control gate of the LS transistor 153. The HS transistor and LS transistor are arranged in series in a power train 151 which receives Vin (an input or power supply voltage) at a power supply node 154. An inductor L is coupled on one side to a switching node 155 between the HS and LS transistors and on another side to an output node 156 which provides an output voltage. A capacitor C and current source 157 are coupled in parallel to the output node and to ground.

As mentioned, the power train and associated components including the inductor, capacitor C and current source may be fabricated on a Gallium Nitride substrate.

The HS and LS transistors may be asymmetric transistors, for example, such as n-type metal-oxide-semiconductor field-effect transistors (MOSFETs). In an asymmetric MOSFET, the source and drain regions have different doping levels or are made of different materials. This results in an asymmetrical structure where the transistor has different electrical properties depending on the direction of current flow. Asymmetric MOSFETs can be used to improve efficiency and reduce switching losses. An asymmetric transistor is denoted by a transistor symbol in which one side is thicker than the other. A symmetric transistor is denoted by a transistor symbol in which both sides have the same thickness.

FIG. 2 depicts example waveforms in a switching cycle of the converter of FIG. 1, including an ideal case and a false trigger case, in accordance with various embodiments. The waveform 200 denotes lsh_in, the waveform 205 denotes Vbst, the waveform 210 denotes Vsw, the waveform 215 denotes VgHS, the control gate voltage of the HS transistor 152, which is the same as lsh_out=lsh_in+Vsw, the waveform 220 denotes Vgs-HS, the gate-to-source voltage of the HS transistor 152, assuming a driver delay=0, and the waveform 225 denotes Vgs-LS, the gate-to-source voltage of the LS transistor 153.

The above waveforms represent the ideal case with no false trigger of the HS transistor. For the case of a false trigger, the waveform 230 denotes VgHS, and the waveform 235 denotes Vgs-HS. The false trigger is represented by the spikes 231 and 236 at t6 to t7. The trigger refers to a temporary turn on of the HS transistor.

The waveforms extend in an example switching cycle which includes first and second phases. The switching cycle is repeated as long as the voltage converter is running. In the first phase (phase 1), a charge phase, the circuit charges the inductor L and in the second phase (phase 2), a discharge phase, the inductor discharges.

A time line with time points t0 to t7 is also depicted. t0 represents the end of a prior switching cycle in phase 2 in which the LS transistor discharges, as denoted by the decrease in Vgs-LS from Vdrv to 0 V (waveform 225). t1 denotes the start of phase 1 in the current switching cycle. At this time, lsh_in increases from 0 V to Vdrv (waveform 200), which may be a fixed positive voltage. This results in a corresponding increase in VgHS (waveforms 215 and 230) and Vg-HS (waveforms 220 and 235) from 0 V to Vdrv. After a delay represented by t2-t1, at t2, Vbst increases from Vdrv to Vin+Vdrv (waveform 205), Vsw increases from 0 V to Vin (waveform 210), and VgHS increases from Vdrv to Vin+Vdrv (waveforms 215 and 230), turning on (making conductive) the HS transistor.

At the start of phase 2, at t3, lsh_in decreases from Vdrv to 0 V (waveform 200). This results in VgHS decreasing from Vin+Vdrv to Vin (waveforms 215 and 230), turning off the HS transistor, and Vgs-HS decreasing from Vdrv to 0 V (waveform 220). After a delay represented by t4-t3, at t4, Vgs-LS increases from 0 V to Vdrv (waveform 225), turning on the LS transistor. The delay is provided by the delay matching and DT control circuit 121.

At t5, Vbst decreases from Vin+Vdrv to Vdrv (waveform 205), and Vsw decreases from Vin to 0 V (waveform 210). This results in VgHS decreasing from Vin to 0 V (waveform 215).

In the case of the false trigger, VgHS spikes back up at t6 to t7 instead of continuing to decrease to 0 V, as represented by the spike 231 in waveform 230. Similarly, Vgs-HS spikes up from 0 V to a level which is greater than its threshold voltage (Vth) at waveform 235. In particular, a high dV/dt can trigger a high coupling current in the level shifter, creating a false trigger which results in shoot-through and efficiency degradation.

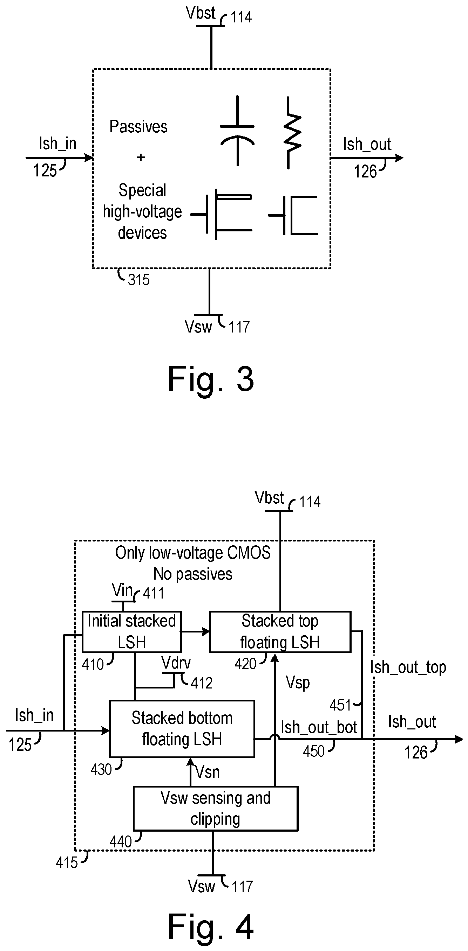

FIG. 3 depicts an example implementation of the floating level shifter 115 of FIG. 1 as a floating level shifter 315 which uses passive devices and special high-voltage devices. As mentioned, the passive devices can includes capacitors and resistors. The special high-voltage devices can include asymmetric devices such as LDMOS and GaN devices. As discussed, the floating level shifter 315 receives Vbst on the path 114, Vsw on the path 117,and the input voltage lsh_in on the input path 125 and outputs lsh_out on the output path 126.

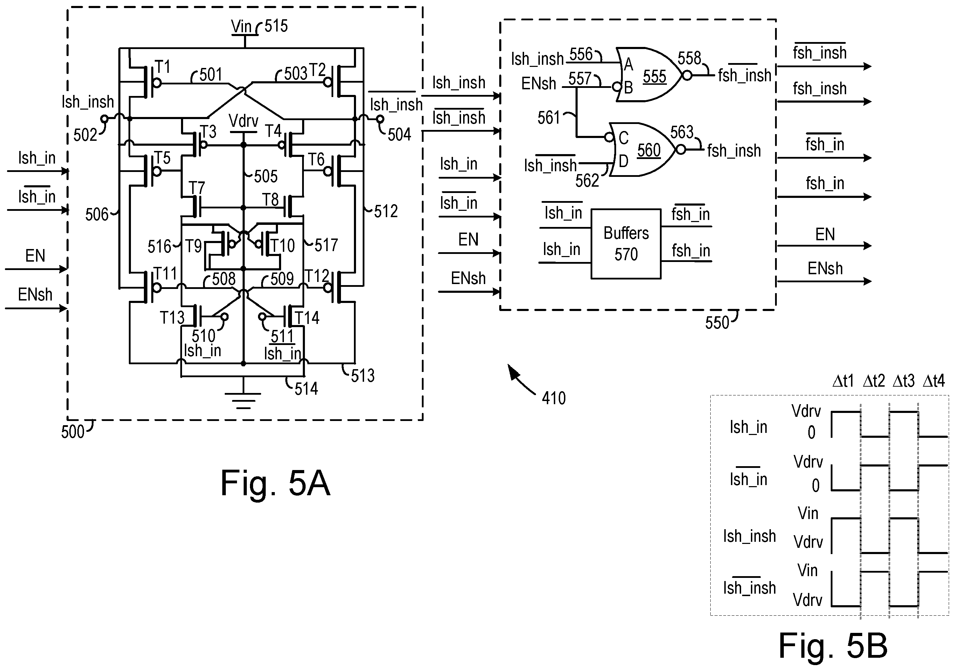

FIG. 4 depicts an example implementation of the floating level shifter 115 of FIG. 1 as a floating level shifter 415 which avoids using passive devices and special high-voltage devices, in accordance with various embodiments. The floating level shifter 415 includes a number of circuits, including an initial (first) stacked level shifter (LSH) 410 which receives Vin at a node 411 and Vdrv at a node 412. The initial stacked LSH 410 is used to shift the input signal lsh_in from between 0 V and Vdrv to between Vdrv and Vin, respectively. lsh_insh is the shifted version of lsh_in. See FIGs. 5A and 5B for further details. In addition to outputting lsh_insh, the initial stacked LSH 410 outputs a number of control signals, including fsh_insh, fsh_insh_bar (where _bar generally denotes the complement or inverse), fsh_in, fsh_in_bar, EN and ENsh, discussed further below. The control signals are used by the stacked top floating level shifter 420, stacked bottom floating level shifter 430 and the Vsw sensing and clipping circuit 440. The stacked top floating LSH 420 is powered by Vbst at the path 114.

In response to the control signals, the Vsw sensing and clipping circuit 440 outputs a first voltage Vsp to the stacked top floating LSH 420, and a second voltage Vsn to the bottom floating level shifter 430. The Vsw sensing and clipping circuit 440 provides Vsp and Vsn by sensing and clipping Vsw, the output voltage of the power train 151 at the path 117.

Vsn is provided to the stacked bottom floating LSH 430 which also receives lsh_in on the path 125 and Vdrv at the node 412. Vsp will vary between Vdrv and Vin as lsh_in varies between 0 V and Vdrv, respectively. Vsn will vary between 0 V and Vdrv as lsh_in varies between 0 V and Vdrv, respectively. Moreover, Vsn is a delayed version of lsh_in, where the delay is caused by the Vsw sensing and clipping circuit 440.

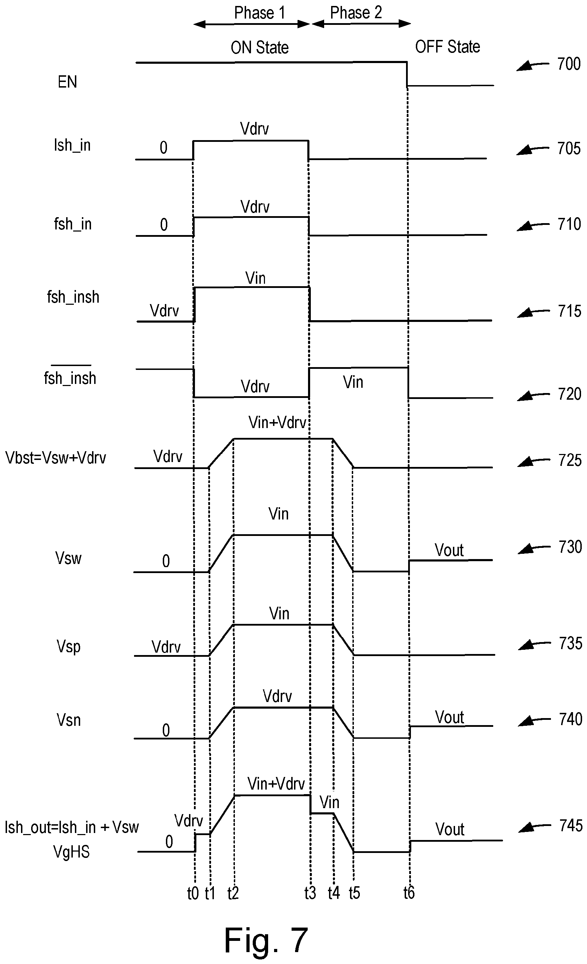

The stacked top floating LSH 420 is only ON when Vsw=Vin, and the stacked bottom floating LSH 430 is only ON when Vsw=0 V, in an example implementation. Thus, only one of them is on at a given time. See also FIG. 7.

lsh_out is provided on the output path 126 based on a voltage Ish_out_top output from the stacked top floating LSH 420 on a path 451, when the stacked top floating LSH 420 is ON, or a voltage Ish_out_bot output by the stacked bottom floating LSH 430 on a path 450, when the stacked bottom floating LSH 430 is ON.

FIG. 5A depicts an example implementation of the initial stacked level shifter 410 of FIG. 4, in accordance with various embodiments. The circuit is in a stacked configuration because it has multiple transistors arranged in series. The initial stacked level shifter 410 includes a first part which is a level shifting circuit 500 and a second part which is a logic circuit 550. The level shifting circuit 500 receives lsh_in, lsh_in_bar, lsh_insh, lsh_insh_bar, Vin and Vdvr as inputs. lsh_insh is a shifted version of lsh_in. level shifting circuit is used to shift the input signal lsh_in from between 0 V and Vdrv to between Vdrv and Vin, respectively, as seen in FIG. 5B. The logic circuit used to provide the control signals fsh_insh, fsh_insh_bar, fsh_in, fsh_in_bar, EN and ENsh to other circuits of the level shifter 415.

The level shifting circuit includes a number of p-type MOSFET (pMOS) and n-type MOSFET (nMOS) transistors. The transistors, denoted by "T," are in a stacked or serial configuration. The turn on condition of a pMOS transistor is Vgs<-Vth. The turn on condition of an nMOS transistor is Vgs>Vth. The level shifting circuit receives Vin at a node 515. Vin is provided to the body/substrate of the serially-connected pMOS transistors T1, T5 and T11 at the left side on a path 506, and to the body/substrate of the serially-connected pMOS transistors T2, T6 and T12 at the right side on a path 512. Vin is also provided to the source side of T1 and T2. Vdrv is provided via a path 505 to the control gates of the transistors T3, T4, T7 and T8, and to the drain side of the transistors T9, T10, T11 and T12. In the figures, the top or bottom side of a pMOS transistor is considered to be the source or drain side, respectively. And, the top or bottom side of an nMOS transistor is considered to be the drain or source side, respectively.

The control gate of T1 is coupled via a path 501 to the source side of T4, the output node 504, the drain side of T2 and the source side of T6. The control gate of T2 is coupled via a path 503 to the source side of T3, the output node 502, the drain side of T1 and the source side of T5. T1 and T2 are in a cross coupled configuration. A path 516 couples the source of T7 to the drain of T13, the source of T9 and the control gate of T10. A path 517 couples the source of T8 to the drain of T14, the source of T10 and the control gate of T9. T9 and T10 are in a cross coupled configuration.

lsh_in and lsh_in_bar are provided at input nodes 510 and 511, respectively. lsh_in is provided to control gates of nMOS transistors T12 (via path 509) and T13. lsh_in_bar is provided to control gates of pMOS transistors T11 (via path 508) and T14. A path 513 couples the drain of T12 to the drain of T11, and a path 514 couples the drain of T14 to the drain of T13.

The control gate of T9 is coupled to the source of T10, the source of T8, and the drain of T14 (via path 517). The control gate of T10 is coupled to the source of T9, the source of T7 and the drain of T13 via path 517. The drain of T10 is coupled to the drain and body of T9.

The nodes 502 and 504 provide the shifted output voltages lsh_insh and lsh_insh_bar, respectively to the logic circuit 550. The logic circuit also receives lsh_in and lsh_in_bar as inputs. The logic circuit includes NOR gates 555 and 560 and buffers 570, in an example implementation. The buffers are used to provide a delay to match a delay of the NOR gates 555 and 560. The NOR gate 555 has a first input path 556 which receives lsh_insh at an input A, a second input path 557 which receives ENsh, so that the input B receives ENsh_bar, and an output 558 which provides fsh_insh_bar. The NOR gate 560 has a first input 561 which receives ENsh, so that the input C receives ENsh_bar, a second input path 562 which receives lsh_insh_bar at an inpt D, and an output 563 which provides fsh_insh. The buffers 570 receive lsh_in_bar and lsh_in on respective inputs, to provide fsh_in_bar and fsh_in, respectively, on respective outputs. Based on the internal logic operations, the logic circuit may output the signals fsh_insh_bar, fsh_insh, fsh_in_bar, fsh_in, EN and ENsh. The logic circuit may ensure that no input signal is higher than Vdrv in the OFF state to avoid any electrical over stress (EOS)/thermal damage issues.

fsh_insh and fsh_insh_bar are examples of first control signals and fsh_in and fsh_in_bar are examples of second control signals. Generally, the fsh* signals are modified versions of the lsh* signals taking into account the enable signal. The logic implemented by the logic circuit 550 results in the waveforms of FIG. 7.

EN and ENsh denote enable signals for the floating level shifter 415. The shifter is enabled when it is operating and not in the off state. EN and ENsh can be input to both the level shifting part 500 and the logic circuit 550.

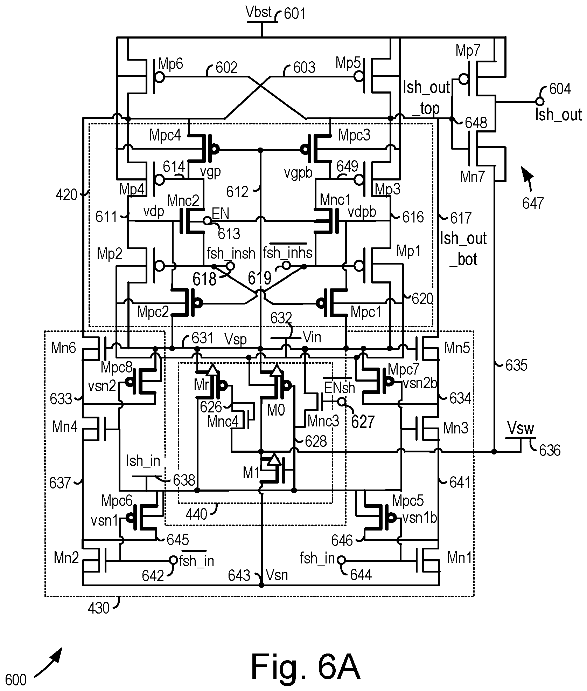

FIG. 5B depicts example waveforms representing the input signals to the logic circuit 550 of FIG. 5A, in accordance with various embodiments. The waveforms are depicted in four consecutive time periods Δt1, Δt2, Δt3 and Δt4. Δt1 and Δt2 correspond to one switching cycle and Δt3 and Δt4 correspond to a next switching cycle. lsh_in=Vdrv in Δt1 and Δt3 and 0 V in Δt2 and Δt4. lsh_in_bar=0 V in Δt1 and Δt3 and Vdrv in Δt2 and Δt4. lsh_insh=Vin in Δt1 and Δt3 and Vdrv in Δt2 and Δt4. lsh_insh_bar=Vdrv in Δt1 and Δt3 and Vin in Δt2 and Δt4. Note that Vin>Vdrv. These control signals, along with EN and ENsh, are provided to the circuit of FIG. 6A.

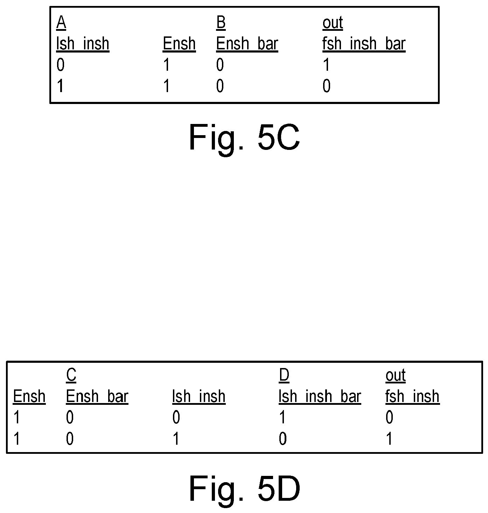

FIG. 5C depicts a truth table consistent with the NOR gate 555 of the logic circuit of FIG. 5A, in accordance with various embodiments. The case with Ensh=1 or enabled is the relevant case. When lsh_insh=0, the output is fsh_insh_bar=1. When lsh_insh=1, the output is fsh_insh_bar=0.

FIG. 5D depicts a truth table consistent with the NOR gate 560 of the logic circuit of FIG. 5A, in accordance with various embodiments. The output fsh_insh is the complement of the output in FIG. 5C. Specifically, when lsh_insh=0, the output is fsh_insh=0, and when lsh_insh=1, the output is fsh_insh=1.

FIG. 6A depicts an example implementation of a circuit 600 which includes the stacked top floating level shifter 420, stacked bottom floating level shifter 430 and the Vsw sensing and clipping circuit 440 (sense and clip circuit) of FIG. 4, in accordance with various embodiments. The circuits 420 and 430 are in a stacked configuration because they have multiple transistors arranged in series. The number of stacked devices depends on Vin-Vdrv. In particular, each low voltage CMOS device has a maximum Vds (drain-to-source voltage) rating that cannot be exceeded. The stacking of n devices can support n*Vds. For the configuration to support a high voltage, a sufficient number of devices can be stacked as necessary to support the maximum voltage that can be seen by the devices. In the floating level shifter described herein, Vmax will be Vin-Vdrv, where Vin is the input voltage of VR and Vdv is the driver voltage.

The circuit 600 has a number of inputs including Vbst at a node 601, EN at a node 613, fsh_insh at a node 618, fsh_inhs_bar at a node 619, Vin at a node 632, lsh_in at a node 638, ENsh_bar at a node 627, fsh_in_bar at a node 642 and fsh_in at a node 644. ENsh is a shifted version of EN obtained using a simple level shifter circuit. The enable signal can be provided from a controller at the SoC level, for instance, to decide when to turn OFF and turn ON the VR.

An output of the circuit is lsh_out at node 604. This is the voltage used to drive the HS transistor. A voltage lsh_out_top on a path 602 is output from the top floating level shifter 420, and a voltage lsh_out_bot on a path 617 is output from the bottom floating level shifter 430. One of these voltages at the node 648 is output as lsh_out at the node 604 according to the on/off states of the transistors Mp7 and Mn7, which form a multiplexer 647. The node 648 provides a selected output for a high dV/dt-immune implementation. The multiplexer, and the source of Mn7, are coupled to the Vsw node 636 via a path 635.

The notation "Mp" denotes a pMOS transistor and the notation "Mn" denotes an nMOS transistor. The notation "Mpc" denotes a cross-switched pMOS transistor and the notation "Mnc" denotes a cross-switched nMOS transistor. The transistors depicted by thick lines, with no triangle icon, are devices used to control an internal node voltage of the stack for EOS mitigation. The transistors depicted by thick lines, with a triangle icon, are Vsw sense devices. An internal node is any node between two series stacked devices or any node for which the value is not controlled. Example internal nodes are path 614 at Vgp, path 649 at Vgpb, and paths 611, 637, 633, 616, 634 and 631.

The top stacked floating level shifter 420 provides a digital differential configuration. It receives power from the voltage Vbst at the node 601 and a ground voltage of Vsp at path 631. It is ON only when Vsw=Vin. In the Vsw sensing and clipping circuit 440, Vsw at node 636 is sensed by the transistors M0 and Mr. The circuits are configured so that Vsp=Vin when Vsw=Vin, and Vsp=Vdrv when Vsw=0 V.

The bottom stacked floating level shifter 430 also provides a digital differential configuration. It receives power from the voltage Vbst at the node 601 and a ground voltage of Vsn at path 643. It is ON only when Vsw=0 V. In the Vsw sensing and clipping circuit 440, Vsw at node 636 is sensed by M1. The circuits are configured so that Vsn=0 V when Vsw=0 V, and Vsn=Vdrv when Vsw=0 V.

At the top of the circuit 600, Vbst is provided to the source and body of Mp5 and Mp6, and to the body of Mp3 and Mp4. Mp2, Mp4 and Mp6 are connected in series at the left hand side and Mp1, Mp3 and Mp5 are connected in series at the right hand side. A path 602 is coupled to the control gate of Mp6, a source of Mpc3, a source of Mp3, the node 648 and the drain of Mn5. A path 603 is coupled to the control gate of Mp5, a source of Mpc4, a source of Mp4 and the drain of Mn6. Vgp denotes a drain voltage of Mpc4 and vgpb denotes a drain voltage of Mpc3. Vsp denotes a gate voltage of Mpc4 and Mpc3. Vdp denotes a gate voltage of MNc2 and vdpb denotes a gate voltage of Mnc1. fsh_insh at node 618 is coupled to the control gates of Mpc1 and Mp2, while fsh_insh_bar at node 619 is coupled to the control gates of Mpc2 and Mp1.

A path 611 couples a source of Mp4 to a source of Mp2, a control gate of Mnc2 and a source of Mpc2. A path 616 couples a source of Mp3 to a source of Mp1, a control gate of Mnc1 and a source of Mpc1.

A path 620 couples a body of Mp1 to a body of M0 and a body of Mpc7, a body of M0, and a body of Mp2. A path 631 couples a control gate of Mn6 to a drain of Mp2, a source of Mpc8, a drain of Mpc2, a source of Mr, the control gates of Mpc4 and Mpc3, a drain of Mnc3, a drain of Mpc1, a source of Mpc7, a drain of Mp1 and a control gate of Mn5.

In the bottom floating level shifter 430, a path 633 couples a body of Mn6 with a drain of Mn4 and a drain of Mpc8, and a path 637 couples a source of Mn4 with a drain of Mn2 and a drain of Mpc6 via a path 645. Also, a path 634 couples a body of Mn5 with a drain of Mn3 and a drain of Mpc7, and a path 641 couples a source of Mn3 with a drain of Mn1 and a drain of Mpc5 via a path 646. fsh_in_bar at node 642 is coupled to the control gates of Mn2 and Mpc6, and fsh_in at node 644 is coupled to the control gates of Mn1 and Mpc5.

In the Vsw sensing and clipping circuit 440, a path 626 couples the control gate of Mr to the drain and control gate of Mnc4. The source of Mnc4 is coupled to Vsw at node 636. Additionally, a path 628 couples the control gate of M0 to the source of Mnc3 to lsh_in at the node 638.

FIGs. 5A and 6A show details of an example high-voltage floating level shifter circuit which is immune to high-voltage changes in dV/dt. The floating level shifter is all-digital with no special devices or passives due to sensing and clipping Vsw and stacking low-voltage CMOS devices to block the high-voltage. Hence, the floating level shifter results in a smaller form-factor (>100x area benefit) compared to other options.

The fact that the floating level shifter is high-voltage, and the power and ground rails are switching signals and not synchronized with the input, place a requirement to think about different and unusual implementations that can work across different inductor switching phases with different rails and input voltage levels with no electrical over stress (EOS) risk.

The input connections of the floating level shifter are the level shifter inputs coming from the controller, lsh_in, the enable signal, EN, and the power switching rails: Vbst and Vsw. In traditional implementations where passives or LDMOS are used to block high-voltage, Vbst and Vsw are the power and ground signals respectively. While in the floating level shifter disclosed herein, Vbst is the power signal and Vsn and Vsp are the ground signals generated from Vsw by sense devices M0, M1 and Mr. This helps support all the switching cases with two differential stacked configurations connected between the common top crosscoupled arrangement (tied to the power Vbst) and the two generated ground signals Vsn and Vsp. The floating level shifter utilizes digital sense devices M0, M1, Mr and the cross devices Mpc7 and Mpc8 to disable/enable different stacked configurations based on the sensed Vsw voltage level (e.g., Vsw=0 or Vin). In addition, cross switches Mpc1 through Mpc8 are used to drive the internal nodes of the stack to voltage levels that avoid having any device exceed the CMOS voltage rating during operation.

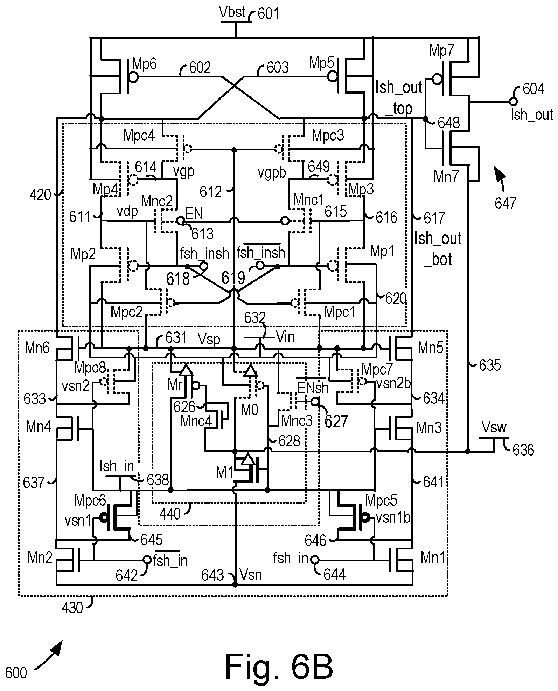

FIG. 6B depicts an example configuration of the circuit of FIG. 6A during an inductor discharge phase, in accordance with various embodiments. Refer also to the inductor L in FIG. 1 and the waveforms of FIG. 7. This refers to the second phase of a switching cycle, where the first phase involves charging the inductor. During the discharging, Vsw=0 V and Vbst=Vdrv. Additionally, lsh_in switches from Vdrv to 0 V. Here, the stacked top floating LSH 420 is OFF, and the bottom floating LSH 430 is ON. Further, Vsp=Vdrv and Vsn=0 V. The transistors depicted by dotted lines are OFF.

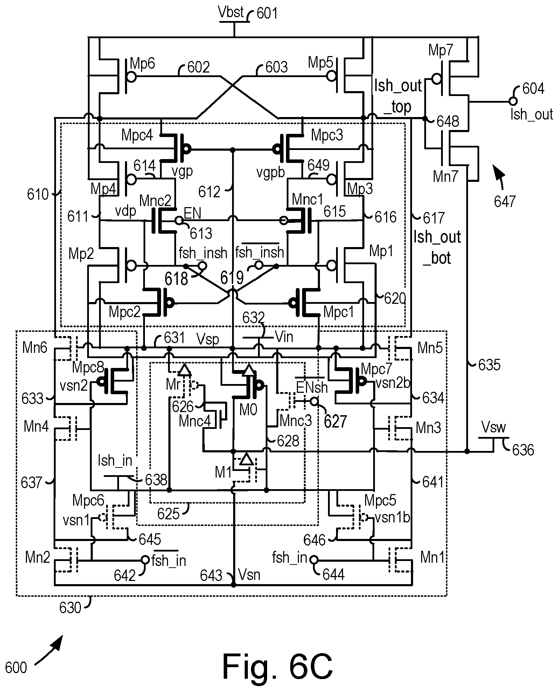

FIG. 6C depicts an example configuration of the circuit of FIG. 6A during an inductor charge phase, in accordance with various embodiments. This refers to the first phase of the switching cycle. During the charging, Vsw=Vin and Vbst=Vin+Vdrv. lsh_in switches from 0 to Vdrv. Here, the stacked top floating LSH 420 is ON, and the bottom floating LSH 430 is OFF. Further, Vsp=Vin and Vsn=Vdrv. As before, the transistors depicted by dotted lines are OFF. The transistor Mpc7 turns off to disable the bottom floating LSH 430 and ensure the device voltage rating is not exceeded.

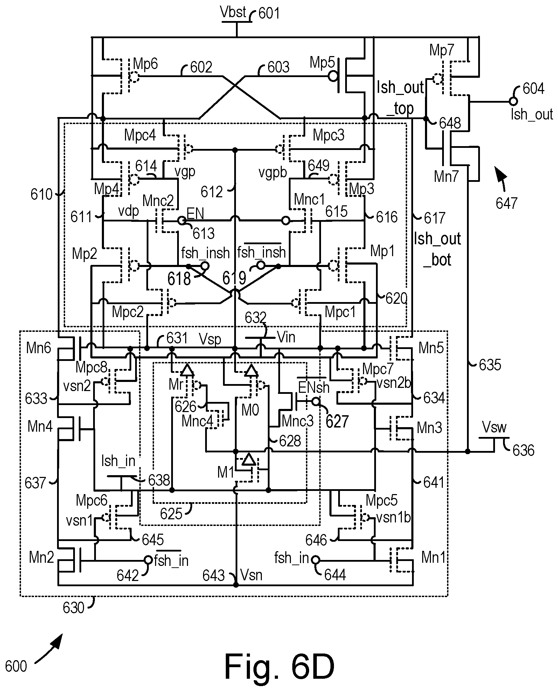

FIG. 6D depicts an example configuration of the circuit of FIG. 6A during an off state, in accordance with various embodiments. In the off state, Vbst=Vdrv, Vsw<Vout, EN=0 and ENsh=Vdrv. There is no current path between any rails. Moreover, leakage current is advantageously very small, e.g., in the pico Amp (pA) range. Vsp=Vdrv and Vsn=Vout.

FIGs. 6B to 6D show the different inductor switching phases for a buck converter using a driver voltage, Vdrv. The bootstrap voltage, Vbst, can go as high as Vin+Vdrv and Vsw can go as high as Vin. The floating level shifter is using the available low-voltage CMOS in an example implementation.

In particular, FIG. 6B shows the enabled devices and differential stacked configuration at Vsw=0 while FIG. 6C shows the enabled devices and differential stacked configuration at Vsw=Vin. FIG. 6D shows the topology in the OFF state. The digital topology of the floating level shifter results in only pA level leakage which makes it the best solution for applications with stringent requirements on leakage such as client applications. All traditional analog- and passive-based implementations cannot provide such a low leakage implementation.

Moreover, since the architecture is fully digital and one branch can always be turned OFF at a time, this makes it possible to implement a seamless high dV/dt-immune topology. As shown in FIG. 6A, the output is deliberately tapped from the branch that will be OFF (with current I=0) during a Vsw high to low transition (i.e., fsh_in=0, fsh_insh=Vccdrv at the Vsw high to low transition). Hence, there is no chance for current coupling or false triggering so dV/dt has no impact on the level shifter, contrary to traditional level shifters.

FIG. 7 depicts example waveforms representing the operation of the circuit of FIG. 6A, in accordance with various embodiments. The waveforms extend during an ON state of the circuit, where phases 1 and 2 represent charging and discharging, respectively, of the inductor, consistent with FIG. 6B and 6C, respectively. The waveforms also extend during an OFF state of the circuit, consistent with FIG. 6D. A time line for the waveform includes time points t0 to t6.

A waveform 700 depicts EN, an enable signal. This signal, when at a high level, enables the circuit to be ON. EN goes low at t6 to start the OFF state in this example. A waveform 705 denotes lsh_in, which is set to Vdrv during phase 1, from t0 to t3. A waveform 710 denotes fsh_in, which is set to Vdrv during phase 1. A waveform 715 denotes fsh_insh, a shifted version of fsh_insh, which is set to Vin during phase 1 and Vdrv at other times. A waveform 720 denotes fsh_insh_bar, the complement of fsh_insh, which is set to Vdrv during phase 1 and Vin at other times. A waveform 725 denotes Vbst=Vsw+Vdrv, which is set to Vin+Vdrv during phase 1 and Vdrv at other times. A waveform 730 denotes Vsw, which is set to Vin during phase 1, 0 V in phase 2, and Vout during the OFF state. A waveform 735 denotes Vsp, which is set to Vin during phase 1 and Vdrv at other times. A waveform 740 denotes Vsn, which is set to Vdrv during phase 1, 0 V in phase 2, and Vout during the OFF state.

A waveform 745 denotes lsh_out=lsh_in+Vsw, which is set to Vdrv at t0 to t1, when lsh_in increases to Vdrv. lsh_out then increases to Vin+Vdrv at t1 to t3 as Vsw increases to Vin. lsh_out then decreases to Vin at t3 to t4 as lsh_in decreases to 0 V. lsh_out then decreases to 0 V at t4 to t6 as Vsw decreases to 0 V. Finally, lsh_out increases to Vout at t6 in the OFF hase.

Generally, the waveforms show the generated ground rails, Vsp and Vsn from Vsw. At Vsw=0, Vbst=Vsp, disabling the top level shifter configuration, while at Vsw=Vin, the cross switches Mpc7 and Mpc8 are turned ON to disable the bottom configuration and Vsn=Vdrv to ensure no device exceeds the maximum device ratings.

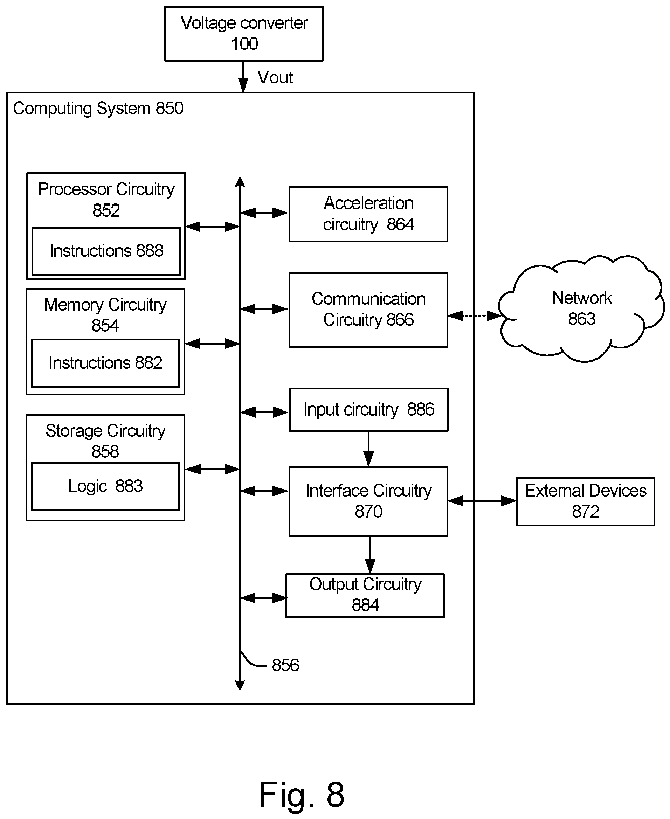

FIG. 8 illustrates an example of components that may be present in a computing system 850 for implementing the techniques (e.g., operations, processes, methods, and methodologies) described herein. The voltage converter 100, such as discussed in connection with FIG. 1, may provide a voltage Vout to one or more of the components of the computing system 850. The voltage converter may be controlled by control signals provided by the processor circuitry 852.

The memory circuitry 854 may store instructions and the processor circuitry 852 may execute the instructions to perform the functions described herein.

The computing system 850 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 850, or as components otherwise incorporated within a chassis of a larger system. For one embodiment, at least one processor 852 may be packaged together with computational logic 882 and configured to practice aspects of various example embodiments described herein to form a System in Package (SiP) or a System on Chip (SoC).

The system 850 includes processor circuitry in the form of one or more processors 852. The processor circuitry 852 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 852 may include one or more hardware accelerators (e.g., same or similar to acceleration circuitry 864), which may be microprocessors, programmable processing devices (e.g., FPGA, ASIC, etc.), or the like. The one or more accelerators may include, for example, computer vision and/or deep learning accelerators. In some implementations, the processor circuitry 852 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 852 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multicore processor, a multithreaded processor, an ultra-low-voltage processor, an embedded processor, or any other known processing elements, or any suitable combination thereof. The processors (or cores) 852 may be coupled with or may include memory/storage and may be configured to execute instructions stored in the memory/storage to enable various applications or operating systems to run on the platform 850. The processors (or cores) 852 is configured to operate application software to provide a specific service to a user of the platform 850. In some embodiments, the processor(s) 852 may be a special-purpose processor(s)/controller(s) configured (or configurable) to operate according to the various embodiments herein.

As examples, the processor(s) 852 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 852 may be a part of a system on a chip (SoC), System-in-Package (SiP), a multi-chip package (MCP), and/or the like, in which the processor(s) 852 and other components are formed into a single integrated circuit, or a single package, such as the Edison^{™} or Galileo^{™} SoC boards from Intel^{®} Corporation. Other examples of the processor(s) 852 are mentioned elsewhere in the present disclosure.

The system 850 may include or be coupled to acceleration circuitry 864, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 864 may comprise logic blocks or logic fabric and other interconnected resources that may be programmed (configured) to perform various functions, such as the procedures, methods, functions, etc. of the various embodiments discussed herein. In such implementations, the acceleration circuitry 864 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 852 and/or acceleration circuitry 864 may include hardware elements specifically tailored for machine learning and/or artificial intelligence (AI) functionality. In these implementations, the processor circuitry 852 and/or acceleration circuitry 864 may be, or may include, an AI engine chip that can run many different kinds of AI instruction sets once loaded with the appropriate weightings and training code. Additionally or alternatively, the processor circuitry 852 and/or acceleration circuitry 864 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 852 and/or acceleration circuitry 864 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 970 provided by Huawei^{®}, and/or the like. In some hardware-based implementations, individual subsystems of system 850 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 850 also includes system memory 854. Any number of memory devices may be used to provide for a given amount of system memory. As examples, the memory 854 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 854 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 854 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 858 provides persistent storage of information such as data, applications, operating systems and so forth. In an example, the storage 858 may be implemented via a solid-state disk drive (SSDD) and/or high-speed electrically erasable memory (commonly referred to as "flash memory"). Other devices that may be used for the storage 858 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 854 and/or storage circuitry 858 may also incorporate three-dimensional (3D) cross-point (XPOINT) memories from Intel^{®} and Micron^{®}.

The memory circuitry 854 and/or storage circuitry 858 is/are configured to store computational logic 883 in the form of software, firmware, microcode, or hardware-level instructions to implement the techniques described herein. The computational logic 883 may be employed to store working copies and/or permanent copies of programming instructions, or data to create the programming instructions, for the operation of various components of system 850 (e.g., drivers, libraries, application programming interfaces (APIs), etc.), an operating system of system 850, one or more applications, and/or for carrying out the embodiments discussed herein. The computational logic 883 may be stored or loaded into memory circuitry 854 as instructions 882, or data to create the instructions 882, which are then accessed for execution by the processor circuitry 852 to carry out the functions described herein. The processor circuitry 852 and/or the acceleration circuitry 864 accesses the memory circuitry 854 and/or the storage circuitry 858 over the interconnect (IX) 856. The instructions 882 direct the processor circuitry 852 to perform a specific sequence or flow of actions, for example, as described with respect to flowchart(s) and block diagram(s) of operations and functionality depicted previously. The various elements may be implemented by assembler instructions supported by processor circuitry 852 or high-level languages that may be compiled into instructions 888, or data to create the instructions 888, to be executed by the processor circuitry 852. The permanent copy of the programming instructions may be placed into persistent storage devices of storage circuitry 858 in the factory or in the field through, for example, a distribution medium (not shown), through a communication interface (e.g., from a distribution server (not shown)), over-the-air (OTA), or any combination thereof.

The IX 856 couples the processor 852 to communication circuitry 866 for communications with other devices, such as a remote server (not shown) and the like. The communication circuitry 866 is a hardware element, or collection of hardware elements, used to communicate over one or more networks 863 and/or with other devices. In one example, communication circuitry 866 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 866 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 856 also couples the processor 852 to interface circuitry 870 that is used to connect system 850 with one or more external devices 872. The external devices 872 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 850, which are referred to as input circuitry 886 and output circuitry 884. The input circuitry 886 and output circuitry 884 include one or more user interfaces designed to enable user interaction with the platform 850 and/or peripheral component interfaces designed to enable peripheral component interaction with the platform 850. Input circuitry 886 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 884 may be included to show information or otherwise convey information, such as sensor readings, actuator position(s), or other like information. Data and/or graphics may be displayed on one or more user interface components of the output circuitry 884. Output circuitry 884 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 850. The output circuitry 884 may also include speakers and/or other audio emitting devices, printer(s), and/or the like. Additionally or alternatively, sensor(s) may be used as the input circuitry 884 (e.g., an image capture device, motion capture device, or the like) and one or more actuators may be used as the output device circuitry 884 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 850 may communicate over the IX 856. The IX 856 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 856 may be a proprietary bus, for example, used in a SoC based system.

The number, capability, and/or capacity of the elements of system 850 may vary, depending on whether computing system 850 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 850 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitiory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a first level shifter (410) to upshift an input signal (lsh_in) to provide a shifted signal (lsh_insh) in a charge phase of a switching cycle; a top floating level shifter (420) responsive to the first level shifter to output a respective voltage during the charge phase of the switching cycle; a bottom floating level shifter (430) responsive to the first level shifter to output a respective voltage during a discharge phase of the switching cycle; a multiplexer to select the respective voltage output by the top floating level shifter during the charge phase of the switching cycle and to select the respective voltage output by the bottom floating level shifter during the discharge phase of the switching cycle; and a driver (116) to drive a high-side transistor in a power train based on the respective voltage output selected by the multiplexer.

Example 2 includes the apparatus of Example 1, further comprising a sense and clip circuit (440) to sense and clip a voltage of a switching node, and to provide a first voltage (Vsp) to the top floating level shifter and a second voltage (Vsn) to the bottom floating level shifter, wherein the switching node is in series with and between the high-side transistor and a low-side transistor of the power train.

Example 3 includes the apparatus of Example 2, wherein: the first voltage (Vsp) varies between a drive voltage (Vdrv) and an input voltage (Vin) as the input signal (lsh_in) varies between 0 V and the drive voltage, respectively; the drive voltage is input to the first level shifter; and the input voltage is input to the high-side transistor.

Example 4 includes the apparatus of Example 2 or 3, wherein: the input signal (lsh_in) alternates between 0 V and a drive voltage (Vdrv); the drive voltage is input to the first level shifter; and the second voltage (Vsn) is a delayed version of the input signal.

Example 4a includes the apparatus of any one of Examples 1 to 4, wherein the input signal alternates between 0 V and a drive voltage, Vdrv, and the shifted signal alternates between 0 V and Vdrv+Vsw, where Vsw is a voltage of a switching node which is in series with and between the high-side transistor and a low-side transistor of the power train.

Example 5 includes the apparatus of any one of Examples 1 to 4, further comprising at least one of a voltage converter, a power management integrated circuit, a System on Chip, a System in Package or a computing device in which the first level shifter, the top floating level shifter, the bottom floating level shifter, the multiplexer and the driver are provided.

Example 6 includes the apparatus of any one of Examples 1 to 5, wherein the first level shifter, the top floating level shifter, and the bottom floating level shifter are implemented with complementary metal-oxide semiconductor (CMOS) technology, and the high-side transistor is fabricated on a Gallium Nitride substrate.

Example 7 includes the apparatus of any one of Examples 1 to 6, wherein the first level shifter, the top floating level shifter, and the bottom floating level shifter are implemented without passive devices and without laterally-diffused metal-oxide semiconductor devices.

Example 8 includes the apparatus of any one of Examples 1 to 7, wherein the first level shifter, the top floating level shifter, and the bottom floating level shifter are fully digital; and.

Example 9 includes the apparatus of any one of Examples 1 to 8, wherein the first level shifter, the top floating level shifter, and the bottom floating level shifter each have a stacked configuration.

Example 10 includes the apparatus of any one of Examples 1 to 9, wherein: the first level shifter is to provide first control signals based on the shifted signal and an enable signal, and second control signals based on the input signal; the top floating level shifter is responsive to the first control signals to output the respective voltage during the charge phase; and the bottom floating level shifter is responsive to the first level shifter to output the respective voltage during the discharge phase of the switching cycle.

Example 11 includes the apparatus of any one of Examples 1 to 9, further comprising: an input node to receive a drive voltage; and a bootstrap circuit coupled to the input node, wherein the bootstrap circuit is to provide a bootstrap voltage to the top floating level shifter.

Example 11 includes the apparatus of any one of Examples 1 to 10, wherein: the respective voltage output by the top floating level shifter is Vin+Vdrv during the charge phase; Vin is a power supply voltage of the high-side transistor; Vdrv is an input voltage of the first level shifter; and the respective voltage output by the bottom floating level shifter is 0 V during the discharge phase.

Example 13 includes a voltage converter, comprising: a driver portion implemented on a silicon substrate, the driver portion comprising an input node, a bootstrap circuit coupled to the input node, a floating level shifter coupled to the bootstrap circuit, a high-side driver coupled to the bootstrap circuit and an output of the floating level shifter, a delay circuit coupled to the input node, and a low-side driver coupled to the input node and to an output of the delay circuit; and a driven portion implemented on a Gallium Nitride substrate, the driver portion comprising a high-side transistor in series with a low-side transistor, and a switching node in a series with and between the high-side transistor and the low-side transistor, wherein the high-side transistor is driven by an output of the high-side driver, the low-side transistor is driven by an output of the low-side driver, and the switching node is coupled to the floating level shifter and the high-side driver.

Example 14 includes the voltage converter of Example 13, wherein the floating level shifter is all-digital, implemented without passive devices and comprises complementary metal-oxide semiconductor (CMOS) devices.

Example 15 includes the voltage converter of Example 13 or 14, wherein: a voltage provided by the bootstrap circuit to the floating level shifter alternates between Vdrv, a drive voltage, in a discharge phase of the voltage converter and Vdrv+Vin in a charge phase of the voltage converter; a voltage of the switching node alternates between 0 V in the discharge phase and Vin in the discharge phase; Vin is a power supply voltage of the high-side transistor; and Vdrv is an input voltage to the bootstrap circuit.

Example 16 includes the voltage converter of Example 15, wherein in the charge phase, the floating level shifter is to shift an input signal at Vdrv to Vdrv+Vin at the output of the floating level shifter.

Example 17 includes an apparatus, comprising: a floating level shifter; and a high-side driver for a high-side transistor of a power train, wherein the floating level shifter is responsive to a voltage output from a bootstrap circuit, a voltage of a switching node of a power train and a drive voltage, Vdrv, of the bootstrap circuit to shift an input signal to an output signal in a charge phase of a switching cycle, the output signal is to drive the high-side driver, and the voltage output from the bootstrap circuit and the voltage of the switching node alternate in charge and discharge phases of a switching cycle.

Example 18 includes the apparatus of Example 17, wherein: the input signal alternates between Vdrv in the charge phase and 0 V in a discharge phase of the switching cycle; the output signal alternates between Vin+Vdrv in the charge phase and 0 V in the discharge phase; Vin is a power supply voltage of the power train; and Vdrv is an input voltage to the bootstrap circuit.

Example 19 includes the apparatus of Example 17 or 18, wherein: the floating level shifter and high-side driver are fabricated on a silicon substrate; and the power train is fabricated on a Gallium Nitride substrate.

Example 20 includes the apparatus of any one of Examples 17 to 19, wherein the floating level shifter comprises: a first level shifter to upshift the input signal to provide a shifted signal in the charge phase, and to provide first control signals based on the shifted signal, and second control signals based on the input signal; a top floating level shifter responsive to the first control signals to output a respective voltage during the charge phase; a bottom floating level shifter responsive to the second control signals to output a respective voltage during the discharge phase; and a multiplexer to provide the output signal, wherein to provide the output signal, the multiplexer is to select the respective voltage output by the top floating level shifter during the charge phase and to select the respective voltage output by the bottom floating level shifter during the discharge phase.

Example 21 includes a method comprising: upshifting an input signal to provide a shifted signal in a charge phase of a switching cycle, and to provide first control signals based on the shifted signal and an enable signal, and second control signals based on the input signal; responsive to the first control signals, outputting a respective voltage during the charge phase; responsive to the second control signals, outputting a respective voltage during a discharge phase of the switching cycle; selecting the respective voltage output by the top floating level shifter during the charge phase and selecting the respective voltage output by the bottom floating level shifter during the discharge phase; and driving a high-side transistor in a power train based on the respective voltage output selected by the multiplexer.

Example 22 includes the method of Example 21, further comprising: sensing and clipping a voltage of a switching node, and providing a first voltage to a top floating level shifter and a second voltage to a bottom floating level shifter, wherein the switching node is in series with and between the high-side transistor and a low-side transistor of the power train.

Example 23 includes the method of Examples 21 or 22, further comprising: varying the first voltage between a drive voltage and an input voltage as the input signal varies between 0 V and the drive voltage, respectively; inputting the drive voltage to the initial level shifter; and inputting the input voltage to the power train.

Example 24 includes the method of Examples 22 or 23, further comprising: alternating the input signal between 0 V and a drive voltage; and inputting the drive voltage to the initial level shifter; wherein the second voltage is a delayed version of the input signal.

Example 25 includes the method of any one of Examples 21 to 24, further comprising: alternating the input signal between 0 V and a drive voltage, Vdrv, and alternating the shifted signal between 0 V and Vdrv+Vsw, where Vsw is a voltage of a switching node which is in series with and between the high-side transistor and a low-side transistor of the power train.

Example 26 includes non-transitory machine-readable storage including machine-readable instructions that, when executed, cause a processor or other circuit or computing device to implement the method of any one of Examples 21 to 25.

Example 27 includes a computer program comprising instructions which, when the program is executed by a computer, cause the computer to carry out the method of any one of Examples 21 to 25.

Example 28 includes a method comprising: responsive to a voltage output from a bootstrap circuit, a voltage of a switching node of a power train and a drive voltage, Vdrv, of the bootstrap circuit, shifting an input signal to an output signal in a charge phase of a switching cycle; driving a high-side driver with the output signal; and alternating the voltage output from the bootstrap circuit and the voltage of the switching node in charge and discharge phases of a switching cycle.

Example 29 includes the method of Example 28, further comprising: alternating the input signal between Vdrv in the charge phase and 0 V in a discharge phase of the switching cycle; and alternating the output signal between Vin+Vdrv in the charge phase and 0 V in the discharge phase; wherein Vin is a power supply voltage of the power train and Vdrv is an input voltage to the bootstrap circuit.

Example 30 includes the method of Example 28 or 29, further comprising: upshifting the input signal to provide a shifted signal in the charge phase, and to provide first control signals based on the shifted signal, and second control signals based on the input signal; responsive to the first control signals, outputting a respective voltage during the charge phase; responsive to the second control signals, outputting a respective voltage during the discharge phase; and to provide the output signal, selecting the respective voltage output by the top floating level shifter during the charge phase and selecting the respective voltage output by the bottom floating level shifter during the discharge phase.

Example 31 includes non-transitory machine-readable storage including machine-readable instructions that, when executed, cause a processor or other circuit or computing device to implement the method of any one of Examples 28 to 30.

Example 32 includes a computer program comprising instructions which, when the program is executed by a computer, cause the computer to carry out the method of any one of Examples 28 to 30.

In the present detailed description, reference is made to the accompanying drawings that form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a first level shifter to upshift an input signal to provide a shifted signal in a charge phase of a switching cycle;
a top floating level shifter responsive to the first level shifter to output a respective voltage during the charge phase;
a bottom floating level shifter responsive to the first level shifter to output a respective voltage during a discharge phase of the switching cycle;
a multiplexer to select the respective voltage output by the top floating level shifter during the charge phase and to select the respective voltage output by the bottom floating level shifter during the discharge phase; and
a driver to drive a high-side transistor based on the respective voltage output selected by the multiplexer.

2. The apparatus of claim 1, further comprising a sense and clip circuit to sense and clip a voltage of a switching node, and to provide a first voltage to the top floating level shifter and a second voltage to the bottom floating level shifter, wherein the switching node is in series with and between the high-side transistor and a low-side transistor of a power train.

3. The apparatus of claim 2, wherein:
the first voltage varies between a drive voltage and an input voltage as the input signal varies between 0 V and the drive voltage, respectively;
the drive voltage is input to the first level shifter; and
the input voltage is input to the high-side transistor .

4. The apparatus of claim 2 or 3, wherein:
the input signal alternates between 0 V and a drive voltage;
the drive voltage is input to the first level shifter; and
the second voltage is a delayed version of the input signal.

5. The apparatus of any one of claims 1-4, further comprising at least one of a voltage converter, a power management integrated circuit, a System on Chip, a System in Package or a computing device in which the first level shifter, the top floating level shifter, the bottom floating level shifter, the multiplexer and the driver are provided.

6. The apparatus of any one of claims 1-5, wherein the first level shifter, the top floating level shifter, and the bottom floating level shifter are implemented with complementary metal-oxide semiconductor (CMOS) technology, and the high-side transistor is fabricated on a Gallium Nitride substrate.

7. The apparatus of any one of claims 1-6, wherein the first level shifter, the top floating level shifter, and the bottom floating level shifter are implemented without passive devices and without laterally-diffused metal-oxide semiconductor devices.

8. The apparatus of any one of claims 1-7, wherein the first level shifter, the top floating level shifter, and the bottom floating level shifter are fully digital.

9. The apparatus of any one of claims 1-8, wherein the first level shifter, the top floating level shifter, and the bottom floating level shifter each have a stacked configuration.

10. The apparatus of any one of claims 1-9, wherein:
the first level shifter is to provide first control signals based on the shifted signal and an enable signal, and second control signals based on the input signal;
the top floating level shifter is responsive to the first control signals to output the respective voltage during the charge phase; and
the bottom floating level shifter is responsive to the first level shifter to output the respective voltage during the discharge phase of the switching cycle.

11. The apparatus of any one of claims 1-10, further comprising:
an input node to receive a drive voltage; and
a bootstrap circuit coupled to the input node, wherein the bootstrap circuit is to provide a bootstrap voltage to the top floating level shifter.

12. The apparatus of any one of claims 1-11, wherein:
the respective voltage output by the top floating level shifter is Vin+Vdrv during the charge phase;
Vin is a power supply voltage of the high-side transistor;
Vdrv is an input voltage of the first level shifter; and
respective voltage output by the bottom floating level shifter is 0 V during the discharge phase.

13. A voltage converter, comprising:
a driver portion implemented on a silicon substrate, the driver portion comprising an input node, a bootstrap circuit coupled to the input node, a floating level shifter coupled to the bootstrap circuit, a high-side driver coupled to the bootstrap circuit and an output of the floating level shifter, a delay circuit coupled to the input node, and a low-side driver coupled to the input node and to an output of the delay circuit; and
a driven portion implemented on a Gallium Nitride substrate, the drive portion comprising a high-side transistor in series with a low-side transistor, and a switching node in a series with and between the high-side transistor and the low-side transistor, wherein the high-side transistor is driven by an output of the high-side driver, the low-side transistor is driven by an output of the low-side driver, and the switching node is coupled to the floating level shifter and the high-side driver.

14. The voltage converter of claim 13, wherein the floating level shifter is all-digital, implemented without passive devices and comprises complementary metal-oxide semiconductor (CMOS) devices.

15. The voltage converter of claim 13 or 14, wherein:
a voltage provided by the bootstrap circuit to the floating level shifter alternates between Vdrv, a drive voltage, in a discharge phase of the voltage converter and Vdrv+Vin in a charge phase of the voltage converter;
a voltage of the switching node alternates between 0 V in the discharge phase and Vin in the discharge phase;
Vin is a power supply voltage of the high-side transistor; and
Vdrv is an input voltage to the bootstrap circuit.
